Europäisches Patentamt

European Patent Office

Office européen des brevets

(11) Publication number: **0 072 660**
**B1**

(12) **EUROPEAN PATENT SPECIFICATION**

(45) Date of publication of patent specification: **30.12.86**

(21) Application number: **82304222.1**

(22) Date of filing: **10.08.82**

(51) Int. Cl.⁴: **H 01 L 21/28,** H 01 L 21/76,
H 01 L 29/78

(54) **Field effect transistor and method for its production.**

(30) Priority: **10.08.81 JP 124946/81**

(43) Date of publication of application:
**23.02.83 Bulletin 83/08**

(45) Publication of the grant of the patent:
**30.12.86 Bulletin 86/52**

(84) Designated Contracting States:
**DE FR GB**

(56) References cited:
**DE-A-2 911 484**
**FR-A-2 264 398**
**US-A-4 267 011**
**IEEE TRANSACTIONS ON ELECTRON
DEVICES, vol. ED-26,no. 4, April 1979, pages
469-475, New York, USA. M. T. ELLIOTT et al.:
"Size effects in E-beam fabricated MOS
devices"**
**IBM TECHNICAL DISCLOSURE BULLETIN, vol.
21, no. 2, July 1978, pages 731-733, New York,
USA. R. P. ESCH: "Self-aligned gate FET
process with source-drain diffusion prior to
gate definition"**

(73) Proprietor: **FUJITSU LIMITED**
**1015, Kamikodanaka Nakahara-ku
Kawasaki-shi Kanagawa 211 (JP)**

(72) Inventor: **Furuya, Toshikazu
1380-B404, Kamikodanaka Nakahara-ku
Kawasaki-shi Kanagawa 211 (JP)**

(74) Representative: **Skone James, Robert Edmund
et al
GILL JENNINGS & EVERY 53-64 Chancery Lane
London WC2A 1HN (GB)**

Courier Press, Leamington Spa, England.

## Description

The present invention relates to a method of producing a metal insulator semiconductor (MIS) FET in which an active region is surrounded by a thick insulating layer.

A MISFET can control a channel current flowing between a source and a drain by supplying a voltage to a gate electrode formed on a thin insulating film on a semiconductor substrate. A well-known metal-oxide semiconductor (MOS) FET is one kind of MISFET. For example, a number of MOSFETs are produced in a semiconductor chip for an integrated circuit. Active regions of the MOSFETs are formed in a semiconductor substrate and are isolated from each other by a suitable isolation means, e.g., a thick insulating layer which is formed on a field region of the semiconductor substrate and surrounds each of the active regions. The thick insulating layer (i.e., a so-called field insulating layer) is also intended to prevent parasitic MOS effects and parasitic capacitance effects.

In accordance with one aspect of the present invention, we provide a method of producing a field effect transistor comprising the steps of forming a thick insulating layer on a field region of a semiconductor substrate, the thick insulating layer having an inclined surface surrounding an active region of the semiconductor substrate; forming a thin insulating layer on the active region of the semiconductor substrate; forming a gate electrode which crosses the thin insulating layer and extends onto the thick insulating layer by forming a conductive layer on the thick insulating layer and the thin insulating layer, forming a resist layer on the conductive layer, selectively exposing the resist layer to an energy ray to define an unexposed area, developing the resist layer to form a gate electrode resist layer corresponding to the unexposed area, etching selectively the conductive layer by using the developed resist layer as a mask, and forming a source region and a drain region in the active region by selectively introducing impurities into the active region; and is characterised in that during the exposing step portions of the unexposed area are formed above at least the inclined surface of the thick insulating layer which are wider than another portion of the gate electrode above a middle portion of the active region.

With the present invention the gate electrode of the transistor is much improved in that the portions of the gate electrode in the inclined surface of the thick insulating layer and above the end portions of the active region are not narrower than another portion above the middle portion of the active region.

An example of a method and transistor according to the present invention will now be described and contrasted with a conventional method with reference to the accompanying drawings, in which:—

Figure 1 is a schematic plan view of a MOSFET produced by a conventional method.

Figure 2 is a schematic view taken on the line II—II in Figure 1;

Figure 3 is a schematic sectional view of a MOSFET in an intermediate stage of production in accordance with the present invention;

Figure 4 is a schematic plan view of the MOSFET shown in Figure 3; and

Figure 5 is a schematic plan view of a MOSFET produced in accordance with the present invention.

A silicon semiconductor substrate 1 is selectively oxidized to form a thick insulating layer (i.e., a field insulating layer) 2. Namely, silicon semiconductor substrate 1 is thermally oxidized to form a thin silicon dioxide layer (not shown) on substrate 1. A silicon nitride layer (not shown) is deposited on the thin silicon dioxide layer and then is selectively etched by a conventional photoetching method. The portion of silicon substrate 1 which is not covered by the silicon nitride layer is sufficiently thermally oxidized to form thick insulating layer 2 of silicon dioxide. The silicon nitride layer and the thin silicon dioxide layer under it are removed by etching. Thus, thick insulating layer 2 is located on a field region 3 and surrounds active region 4 of silicon substrate 1.

Active region 4 of silicon substrate 1 is slightly oxidized to form thin insulating layer 5 of silicon dioxide.

Then gate electrode 6 is formed on thick insulating layer 2 and thin insulating layer 5 so as to cross active region 4 and extend above field region 3. Namely, aconductive material (e.g., polycrystalline silicon) for gate electrode 6 is deposited on thick insulating layer 2 and thin insulating layer 5 to form a conductive layer. A photoresist (not shown) is applied to the conductive layer, is exposed by a light passing through a photomask having a gate electrode pattern, and is developed to form a gate electrode photoresist pattern (not shown). The portion of the conductive layer which is not covered by the gate electrode photoresist pattern is removed by etching to form gate electrode 6.

In order to form source region S and drain region D in active region 4 of silicon substrate 1, N-type or P-type impurities are introduced into active region 4, except for a portion covered by gate electrode 6, by an ion implantation method. Thereafter, an annealing treatment is carried out. A source electrode and a drain electrode (not shown) are formed in accordance with a conventional method to obtain the MOSFET.

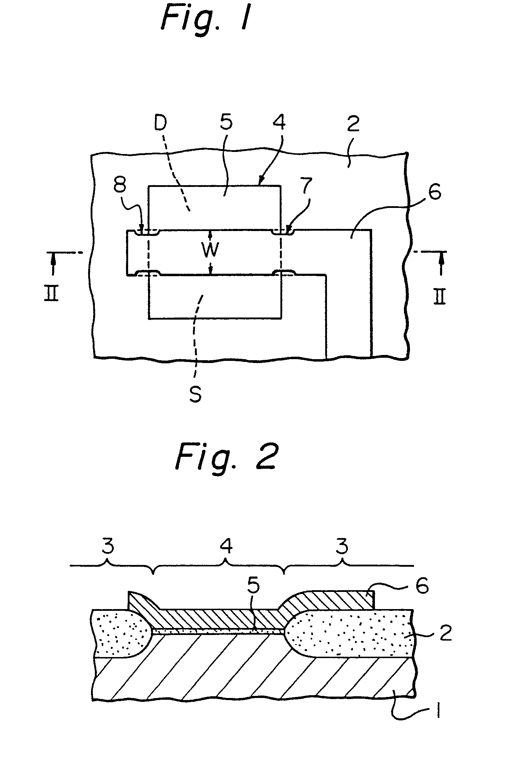

In the case of the above-mentioned production method, however, portions of gate electrode 6 to be formed are undesirably etched on the inclined surface of thick insulating layer 2 and above the end portions of active region 4, as illustrated in Figure 1. Although the gate electrode pattern of the photomask comprises straight sides, constricted portions of the gate electrode photoresist pattern corresponding to constricted portions 7 and 8 of gate electrode 6 are formed due to variation of the photoresist layer thickness and to irregular reflection of the exposing light at the inlined surface of thick insulating layer 2. Therefore, the constricted portions 7 and 8 of gate electrode 6 are formed during the etching step. When source region S and drain region D are formed, projecting portions of these regions are formed next to constricted portions 7 and 8 of gate electrode 6, with the result that the threshold voltage varies, the leakage current is increased, and the breakdown voltage between the source and drain is decreased. The above disadvantages become more serious when a MOSFET having a short width W gate electrode (Figure 1) (i.e., a short channel length) is produced. Such a MOSFET having a short channel length is suitable for a high frequency device. Furthermore, since a photoresist having a high sensitivity is used in the formation of a narrow gate electrode, the constricted portions of the gate electrode photoresist pattern can be more easily formed.

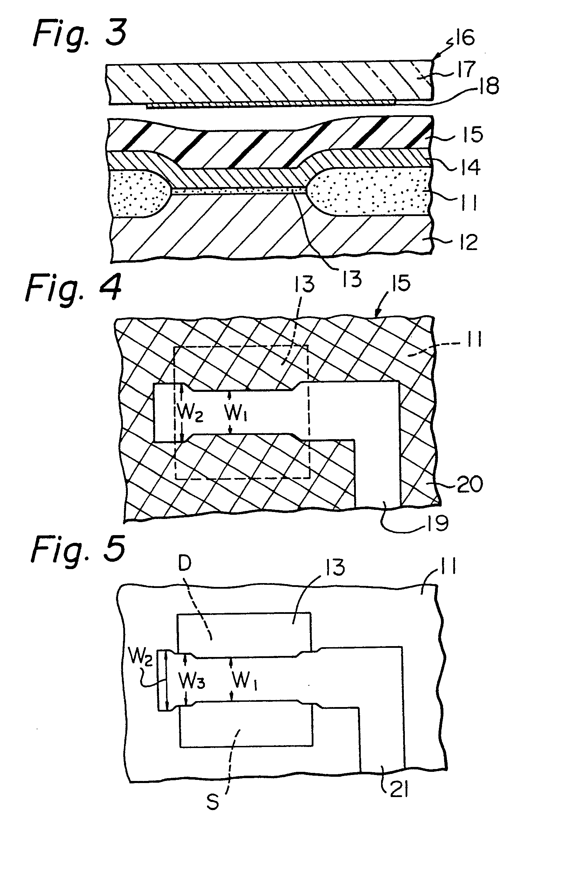

In Figure 3, a thick insulating layer 11 consisting of silicon dioxide is formed by selectively and thermally oxidizing a silicon semiconductor substrate 12 in accordance with the above-mentioned step of the prior art. Then a thin insulating layer 13 consisting of silicon dioxide is formed by thermally oxidizing the active region of semiconductor substrate 12. Polycrystalline silicon as a conductive material is deposited on the thick insulating layer 11 and thin insulating layer 13 by a chemical vapour deposition method to form a conductive layer 14 (Figure 3). It is possible to use molybdenum, tungsten, titanium, tantalum, platinum, or a silicide thereof instead of polycrystalline silicon. In such a case, the above-mentioned metal or silicide is deposited by a sputtering method.

A positive-type photoresist is applied to conductive layer 14 by a spin coating method to form photoresist layer 15. Then photoresist layer 15 is exposed by a light passing through a photomask 16 placed above it. Photomask 16 consists of transparent glass substrate 17 and mask 18 (of e.g. a chromium film) formed on it. Mask 18 has a gate electrode pattern being the same shape as area 19, as shown in Fig. 4. Unexposed area 19 of photoresist layer 15 is indicated by the non-crosshatched portion; exposed area 20 is indicated by the crosshatched portion in Figure 4. As may be seen, width $W_2$ of a portion of unexposed area 19 which is above the inclined surface of thick insulating layer 11 and above the end portion of thin insulating layer 13 is larger than width $W_1$ of another portion of unexposed area 19 which is above a middle portion of thin insulating layer 13. An ultra-violet ray or an X-ray can be used instead of the light passing through the photomask. In this case, a suitable resist for the ultra-violet ray or the X-ray should be used. It is also possible to expose resist layer 15 by using an electron beam instead of a light passing through photomask 16. The exposed photoresist is decomposed and photoresist layer 15 is developed with a suitable developer so that the unexposed area of photoresist layer 15 remains as gate electrode photoresist pattern 21, as illustrated in Figure 5. In this case, width $W_3$ of a portion of remaining photoresist pattern 21, which is above the inclined surface and above the end portion of thin insulating layer 13, is smaller than width $W_2$ of another portion above thick insulating layer 11 and is equal to or larger than width $W_1$ of the other portion above the middle portion of thin insulating layer 13 since irregular reflection and scattering of the exposing light (or the electron beam) occur due to the inclined surface.

Then, using remaining (gate electrode) resist pattern 21 as a mask, conductive layer 14 is etched with a suitable etchant to form a gate electrode under photoresist pattern 21. The shape of the obtained gate electrode is the same as that of photoresist pattern 21.

N-type or P-type impurities are introduced into the active region of silicon substrate 12 through thin insulating layer 13 by an ion-implantation method so that source region S and drain region D are formed. In this case, the gate electrode and photoresist pattern 21 serves as a mask for preventing the impurities from penetrating substrate 12. Photoresist pattern 21 is removed and then the obtained MOSFET is annealed. A source electrode and a drain electrode are formed in accordance with a conventional formation method. If necessary, an insulating film of, e.g. phosphosilicate glass is formed prior to the formation of the source and drain electrodes.

When a voltage is supplied to the gate electrode of the MOSFET, a channel forms between source region S and drain region D and directly below the gate electrode. The channel length under the middle portion of the thin insulating layer is shorter than that under the end portions of the thin insulating layer so that the properties of the MOSFET, such as the threshold voltage, are dependent upon the short channel length under the middle portion. Since the channel length under the end portions of the thin insulating layer is longer than that under the middle portion, it is possible to prevent the above-mentioned disadvantages from occurring at the end portions of the active region.

**Claims**

1. A method of producing a field effect transistor comprising the steps of forming a thick insulating layer (11) on a field region of a semiconductor substrate (12), the thick insulating layer (11) having an inclined surface surrounding an active region of the semiconductor substrate (12); forming a thin insulating layer (13) on the active region of the semiconductor substrate (12); forming a gate electrode which crosses the thin insulating layer (13) and extends onto the thick insulating layer (11) by forming a conductive layer (14) on the thick insulating layer (11) and the thin insulating layer (13), forming a resist layer (15) on the conductive layer (14), selectively exposing the resist layer (15) to an energy ray to define an unexposed area, developing the resist layer (15) to form a gate electrode resist layer (21) corresponding to the unexposed area (19), etching selectively the conductive layer by using the developed resist layer (21) as a mask, and forming a source region (S) and a drain region (D) in the active region by selectively introducing impurities into the active region; characterised in that during the exposing step portions of the unexposed area are formed above at least the inclined surface of the thick insulating layer (11) which are wider than another portion of the gate electrode above a middle portion of the active region.

2. A method according to claim 1, wherein the energy ray comprises light, an ultra-violet ray, an X-ray, or an electron beam.

3. A method according to claim 1 or claim 2, wherein the wider portions of the gate electrode pattern area (19) extend above the end portions of the active region.

**Patentansprüche**

1. Verfahren zur Herstellung eines Feldeffekttransistors mit den Schritten:

Bildung einer dicken isolierenden Schicht (11) auf einem Feldbereich des Halbleitersubstrats (12), wobei die dicke isolierende Schicht (11) eine geneigte Oberfläche hat, die einen aktiven Bereich auf dem Halbleitersubstrat (12) umgibt;

Bildung einer dünnen isolierenden Schicht (13) auf dem aktiven Bereich des Halbleitersubstrats (12);

Bildung einer Gateelektrode, welche die dünne isolierende Schicht (13) kreuzt und sich auf die dicke isolierende Schicht (11) erstreckt, durch Bildung einer leitenden Schicht (14) auf der dicken isolierenden Schicht (11) und der dünnen isolierenden Schicht (13), Bildung einer Resistschicht (15) auf der leitenden Schicht (14), selektive Exponierung der Resistschicht (15) gegenüber einem Energiestrahl, um einen nicht exponierten Bereich zu definieren, Entwicklung der Resistschicht (15), um eine Gateelektroden-Resistschicht (21) zu bilden, die dem nicht exponierten Bereich (19) entspricht, selektives Ätzen der leitenden Schicht durch Verwendung der entwickelten Resistschicht (21) als eine Maske, und Bildung eines Sourcebereichs (S) und eines Drainbereichs (D) in dem aktiven Bereich durch selektive Einführung von Verunreinigungen in den aktiven Bereich;

dadurch gekennzeichnet, daß während des Exponierungsschrittes Abschnitte des nicht exponierten Bereichs oberhalb von wenigstens der geneigten Oberfläche der dicken isolierenden Schicht (11) gebildet werden, welche breiter als ein anderer Abschnitt der Gateelektrode oberhalb eines mittleren Abschnittes des aktiven Bereichs sind.

2. Verfahren nach Anspruch 1, bei welchem der Energiestrahl Licht, einen ultravioletten Strahl, einen Röntgenstrahl, oder einen Elektronenstrahl umfaßt.

3. Verfahren nach Anspruch 1 oder 2, bei welchem die breiteren Abschnitte des Gateelektrodenmusterbereichs (19) sich oberhalb der Endabschnitte des aktiven Bereichs erstrecken.

**Revendications**

1. Procédé de production d'un transistor à effet de champ qui comprend les opérations consistant à former une couche isolante épaisse (11) sur une région de champ d'un substrat semiconducteur (12), la couche isolante épaisse (11) ayant une surface inclinée qui entoure une région active du substrat semiconducteur (12); à former une couche isolante mince (13) sur la région active du substrat semiconducteur (12); à former une électrode de grille qui croise la couche isolante mince (13) et s'étend sur la couche isolante épaisse (11) en formant une couche conductrice (14) sur la couche isolante épaisse (11) et la couche isolante mince (13), en formant une couche en agent sensible du type réserve (15) sur la couche conductrice (14), en exposant sélectivement la couche en agent sensible (15) à un rayonnement d'énergie afin de définir une aire non exposée, en développant la couche en agent sensible (15) pour former une couche en agent sensible d'électrode de grille (21) correspondant à l'aire non exposée (19), en incisant sélectivement la couche conductrice à l'aide de la couche en agent sensible développée (21) utilisée comme masque, et à former une région de source (S) et une région de drain (D) dans la région active en introduisant sélectivement des impuretés dans la région active; caractérisé en ce que, pendant l'opération d'exposition, on forme des parties de l'aire non exposée au-dessus d'au moins la surface inclinée de la couche isolante épaisse (11) qui sont plus larges qu'une autre partie de l'électrode de grille de trouvant au-dessus de la partie moyenne de la région active.

2. Procédé selon la revendication 1, où le rayonnement d'énergie comprend la lumière, un rayonnement ultraviolet, des rayons X, ou un faisceau électronique.

3. Procédé selon la revendication 1 ou 2, où les parties plus larges de l'aire (19) de la configuration d'électrode de grille s'étendent au-dessus des parties terminales de la région active.

*Fig. 1*

*Fig. 2*

*Fig. 3*

*Fig. 4*

*Fig. 5*